# EUROPEAN PATENT APPLICATION

(11) **EP 2 506 328 A1**
(43) Date of publication of application: **03.10.2012**
(21) Application number: 10833199.2
(22) Date of filing: 24.11.2010
(51) Int. Cl.: H01L 51/42

(54) **ORGANIC SOLAR CELL**

(30) Priority: 24.11.2009 JP 2009266169
(71) Applicant: Panasonic Corporation, Kadoma-shi Osaka 571-8501 (JP); Kyushu University, National University Corporation, Fukuoka-shi Fukuoka 812-8581 (JP)
(72) Inventor: KAWANO, Kenji, Osaka-shi, Osaka 540-6207 (JP); ADACHI, Chihaya, Fukuoka-shi Fukuoka 812-8581 (JP)
(74) Representative: Appelt, Christian W.
(86) International application number: PCT/JP2010/070873
(87) International publication number: WO 2011/065353

(57) **Abstract**

This invention has an objective of producing the organic solar cell having the long life. The organic solar cell of this invention comprises a first electrode collecting holes, a second electrode collecting electrons, mixing layer interposed between the first electrode and the second electrode and having an electron donating semiconductor and the electron accepting semiconductor, and a first electron transport layer and a second electron transport layer interposed between the mixing layer and the second electrode. With this invention, the adhesiveness in the boundary between the mixing layer and the second electrode is improved. Consequently, it is possible to prevent the mixing layer from accumulating the electrical charge generated by absorbing the light. Therefore, the electrical charge is efficiently moved to the second electrode and the long life is achieved.

## Description

### TECHNICAL FIELD

This invention relates to an organic solar cell.

### BACKGROUND ART

Since energy consumption is dramatically increasing according to the industrial development, new clean energy having low environmental load, economic, and high performance is researched and developed in various places. The solar cell uses the solar light which is an infinite energy. Therefore, the solar cell draws attention as new energy.

Most of the solar cell now in practical use is an inorganic silicon type solar cell using single crystal silicon, polycrystal silicon type solar cell, and amorphous silicon. However, the inorganic silicon type solar cell has a defect of complex manufacturing process and the high cost. For these reasons, the inorganic silicon type solar cell does not become in common to the standard home broadly. In order to solve this defect, much more research regarding the organic solar cell (organic electrical power generation element) using the organic material is conducted in order to produce the solar cell which is easy to simplify the manufacturing process, reduce the cost, and enlarge its size.

As an example, the dye-sensitized solar cell which is a sort of the organic solar cell which is manufactured with using porous titanium oxide, ruthenium pigment, iodine, and iodine ion is released. The dye-sensitized solar cell has a high conversion efficiency of 10 percents. (Refer to Non Patent literature 1 explained below.)

In addition, in the organic thin film type organic solar cell different in sort from the dye-sensitized solar cell, the organic solar cell having a pair of electrodes having a positive electrode and a negative electrode and the electrical power generation layer having the double heterostructure between the positive electrode and the negative electrode which are formed by the vacuum deposition method of depositing the electron donating semiconductor and the electron accepting semiconductor which are low molecular materials is released. The organic solar cell has a conversion efficiency of 3.6 percents. (Refer to Non Patent literature 2 explained below.)

In addition, as to the material of the electrical power generation layer in the organic solar cell, not only the low molecular material but also high polymer material is now examined. This is because, if the electrical power generation layer is made of the low molecular material, it is necessary to form the electrical power generation layer by means of the vacuum deposition method. In contrast, if the electrical power generation layer is made of the high polymer material, it is possible to form the electrical power generation layer with using the coating technique and the printing technique. Therefore, this advantage brings in reduction of the manufacturing cost.

In the organic solar cell with the high polymer, recently, the organic thin film type solar cell comprising the electrical power generation layer having a mixing layer of the conjugate type polymer and the fullerene derivatives is reported that the organic thin film type solar cell has a conversion efficiency of 5.5 percents. (Refer to Non Patent literature 3 explained below.) So, various research institutes attempt to conduct the artifice and the consideration in order to produce the organic thin film type solar cell.

However, the organic thin film type solar cell has the structure and the material which have a lot in common with respect to those of the organic EL element (organic electroluminescence element). Therefore, the organic thin film type solar cell has a problem of durability in terms of the practical realization.

As to the method of improving the durability of the organic thin film type solar cell, for example, some literatures report the technique of eliminating the oxygen and the water to avoid the degradation of the electrical property. (Refer to Non Patent literature 4 and 5 explained below.)

By the way, in view of the practical realization of the organic thin film solar cell, the organic thin film solar cell has a necessity to have the property of efficiently convert the light into the electrical energy and keep the property over a long period of time. However, even if the techniques of eliminating the oxygen and the water disclosed in Non Patent literatures 4 and 5 is applied to the organic solar cell to improve the durability of the organic solar cell, the property is gradually degrading.

### CITATION LIST

**NON PATENT LITERATURE 1** Christophe J Barbe,et,al, Nanocrystalline Titanium Oxide Electrodes for PhotovoltaicApplication ,J.Am.Ceram.Soc.,80,1997,p.3157-3171
**NON PATENT LITERATURE 2** P.Peumans,et,al, Very-high-efficiency double-heterostructure copper phthalocyanine/C60photovoltaic cells ,APPLIED PHYSICS LETTERS , VOLUME 79 , NUMBER 1,2001,p.126-128
**NON PATENT LITERATURE 3** J.PEET,et,al, Efficiency enhancement in low-bandgap polymer solar cells by processing with alkane dithiols ,nature materials , VOL6 , 2007 , p. 497 - 500
**NON PATENT LITERATURE 4** Kenji Kawano,el,al, Degradation of organic solar cells due to air exposure ,Solar Energy Materials & Solar cells.90,2006,p.3520-3530
**NON PATENT LITERATURE 5** H.Neugebauer et,al, Stability and photodegradation mechanisms of conjugatedpolymer/fullerene plastic solar cells , Solar EnergyMaterials & Solar cells.61,2000,p.35-42

### SUMMARY OF INVENTION

This invention is made in view of the above matter. An objective of this invention is to produce the organic solar cell having the long life.

This invention discloses the organic solar cell comprising a first electrode which collects holes, a second electrode which collects electrons, the mixing layer which is interposed between the first electrode and the second electrode and which comprises an electron donating semiconductor and an electron accepting semiconductor, and a first electron transport layer and a second electron transport layer which are interposed between the mixing layer and the second electrode. The second electron transport layer is formed with a plurality of projections which are in contact with the second electrode.

According to this invention, the adhesiveness in the boundary between the mixing layer and the second electrode is improved. Therefore, when the electrical charge developed in the light absorption in the power generation, it is possible to prevent the accumulation of the electrical charge and to move the electrical charge to the second electrode. Therefore, long life is achieved.

In the above configuration, a plurality of the projections preferably have dome shapes or dot shapes. With this configuration, compared with a case where the projections are formed to have a stripe arrangement, it is possible to increase the dimension of the contact boundary which is provided for passing the electrical charge and which is located between the second electron transport layer and the second electrode. Therefore, it is possible to prevent the effect of accumulation of the electrical charge. Therefore, long life is achieved.

In the above configuration, a plurality of the projections have the dome shapes to have heights with a range from 4 nanometers to 6 nanometers and average diameters with a range from 80 nanometers to 120 nanometers. With this configuration, it is possible to attach the second electrode with the second electron transport layer without space, thereby improving the efficiency of improving the accumulation of the electrical charge. So, long life is achieved.

### BRIEF DESCRIPTION OF DRAWINGS

Fig. 1 shows a schematic cross sectional view of the organic solar cell.
Fig. 2 shows a property explanation illustration of the first example of the above.
Fig. 3 shows a property explanation illustration of the second example of the above.
Fig. 4 shows a property explanation illustration of the comparative example of the above.
Fig. 5A shows an AFM image indicating the surface shape of the second electron transport layer in the first example of the above.
Fig. 5B shows an AFM image indicating a cross sectional view of the surface shape of the second electron transport layer in the first example of the above.
Fig. 6A shows an AFM image indicating the surface shape of the second electron transport layer in the second example of the above.
Fig. 6B shows an AFM image indicating a cross sectional of the surface shape of the second electron transport layer in the second example of the above.
Fig. 7A shows an AFM image indicating the surface shape of the electron transport layer of the comparative example of the above.
Fig. 7B shows an AFM image indicating a cross section of the surface shape of the electron transport layer of the comparative example of the above.

### DESCRIPTION OF EMBODIMENTS

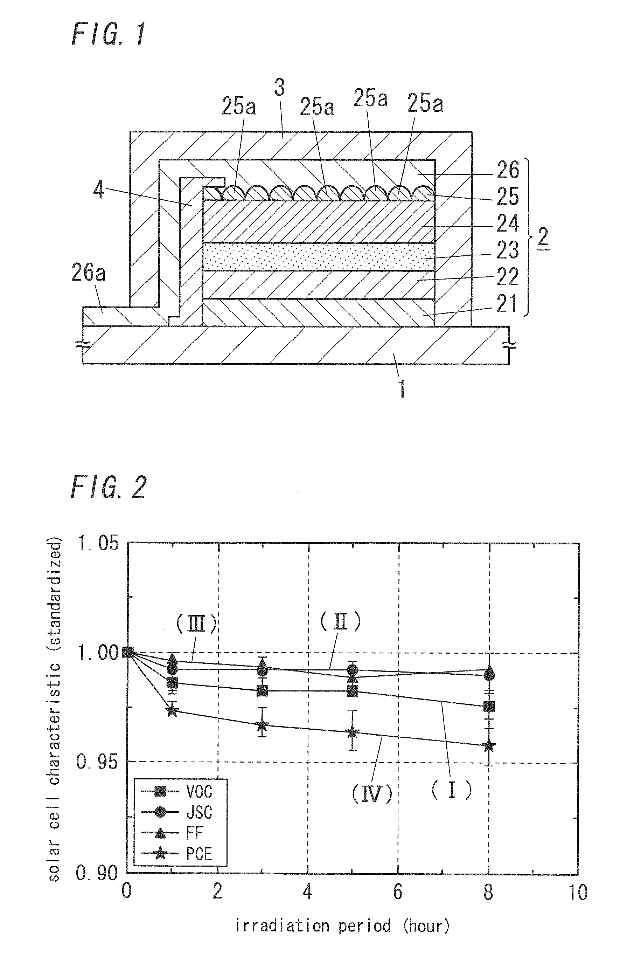

This embodiment discloses the organic solar cell, as shown in Fig. 1, comprising the substrate 1 having a rectangular shape in planar view, an organic solar cell element 2 formed on one surface side of the substrate 1, (an organic solar cell element 2 formed on an upper surface side of the substrate 1), and a surface protection layer 3 formed on one surface side of the substrate 1 to cover the organic solar cell element 2.

The organic solar cell 2 has a positive electrode 21 on one surface side of the substrate 1, a hole transport layer 22 formed on the positive electrode 21, the mixing layer 23 which is an electrical power generation layer (photoelectric conversion layer) formed on the hole transport layer 22 to absorb the solar light and generate the electrical power, the first electron transport layer 24 formed on the mixing layer 23, a negative electrode 26 formed in a position opposite of the first electron transport layer 24 from the mixing layer 23. Furthermore, the second electron transport layer 25 is formed on the first electron transport layer 24. The second electron transport layer 25 is formed by a plurality of the projections 25a which are in contact with the negative electrode 26. In short, in this embodiment, the first electron transport layer 24 having the flat continuous film shape is formed on the mixing layer 23. The first electron transport layer 24 has a second electron transport layer 25 having the projections in contact with the negative electrode 26. The second electron transport layer 25 is formed to mount the negative electrode 26 thereon. In addition, in this embodiment, the positive electrode 21 defines the first electrode being configured to collect the holes. The negative electrode 26 defines the negative electrode 26 being configured to collect the electrons. The positive electrode 21 and the negative electrode 26 define a pair of the electrodes.

The above organic solar cell comprises the substrate 1 which is realized by the transparent substrate and the positive electrode 21 which is realized by the transparent electrode. The substrate 1 has the other surface which is defined as the light incidence surface for entry of the solar light (the light from the outside).

The transparent substrate defining the substrate 1 is not limited to the substrate having clear and colorless. Therefore, the substrate 1 may be realized by the substrate having a little color. The transparent substrate defining the substrate 1 is realized by the glass substrate such as soda lime glass and alkali free glass. However, the substrate 1 is not limited to the glass substrate and may be realized by the plastic film and the plastic substrate made of polyester, polyolefin, polyamide resin, epoxy resin, and fluorine series resin. In addition, the glass substrate may be the frosted glass. In addition, the substrate 1 may have the particles, the powder, and the bubbles having the refraction index different from that of the substrate 1 to have the light scattering property. In addition, in a case where the substrate is not provided on a same side of the light incidence surface of the organic solar cell element 2, the substrate 1 is not limited its material, in particular. Therefore, in this case, any substrate will do if the substrate 1 is capable of fixing the organic solar cell element 2.

In addition, the positive electrode 21 is an electrode for efficiently collect the hole generated in the mixing layer 23. The positive electrode 21 is made of material of ITO. However, the positive electrode 21 is not limited its material to ITO and may be made of material having a high work function such as the metal, alloy, electrical conductive compound, and the mixture of them. In addition, the material should be selected to have the work function from 4 eV or more to 6 eV or less so as to prevent the difference of the HOMO (Highest occupied Molecular Orbital) level from being enlarged. The material of the positive electrode 2 is exemplified by the metal such as gold, CuI, ITO, SnO₂ ZnO, IZO, the electrical conductive polymer such as the PEDOT and polyaniline, the electrical conductive polymer doped with the arbitrary accepter, and the electrical conductive light transmissive material such as carbon nanotube. In addition, the positive electrode 21 may be formed on one surface side of the substrate 1 by means of the vacuum deposition method, sputtering method, and the coating method. In order to provide the solar light to the mixing layer 23 while passing the light through the positive electrode 21, it is preferred that the positive electrode has the light transmissibility of 70 percents or more. In addition, it is preferred that the positive electrode 21 has the sheet resistance of several hundred ohms per square or less. In addition, it is more preferred that positive electrode 21 has the sheet resistance of 100 ohms per square or less. In addition, the positive electrode 21 is arbitrarily determined its thickness according to the light transmissibility of the positive electrode 21 and the sheet resistance. Therefore, although the thickness of the positive electrode depends on its material, the thickness of the positive electrode 21 is arbitrarily set to have, preferably, 500 nanometers or less and to have, more preferably, a range from 10 nanometers or more to 200 nanometers or less.

In addition, the negative electrode 26 is an electrode for effectively collect the electrons generated in the mixing layer 23. Preferably, the material of the negative electrode 26 is made of the metal and alloy having small work function. In addition, the material of the negative electrode is preferably selected to have a work function having a range from 1.9 eV or more to 5 eV or less so as to prevent the difference with respect to the LUMO (Lowest Unoccupied Molecular Orbital) level. The material of the negative electrode 26 is exemplified by the alkali metal, the alkali earth metal, the rare earths, and the alloys including them and the other metal such as sodium, sodium-potassium alloy, lithium, magnesium, magnesium-silver mixture, magnesium-indium mixture, and aluminum-lithium alloy. In addition, aluminum may also use as the material of the negative electrode. In addition, the above mentioned negative electrode 26 is formed on one surface side of the substrate 1 by means of the vacuum deposition method, the sputtering method, and the coating method.

In addition, the electrical donating semiconductor used in the mixing layer 23 is realized by poly-3-hexylthiophene (hereinafter referred to as P3HT) which is a sort of the electrical conductive high polymer material. However, the electrical donating semiconductor is not limited its material thereto, and may be made of material such as phthalocyanine series pigment, indigo, thioindigo series pigment, quinacridone series pigment, merocyanine compound, cyanin, squarylium compound, polyaromatic compound, the charge transfer agent used for the organic electrophotographic photoreceptor, the electrical conductive organic charge transfer complex, and other electrical conductive polymer material. However, any material will do as long as the electrical donating semiconductor dissolves in the solvent. Therefore, the material is not limited thereto.

The phthalocyanine series pigment is exemplified by divalent one having the central metal of Cu, An, Co, Ni, Pb, Pt, Fe, and Mg, triad metal phthalocyanine with coordinate of the halogen atom such as metal-free phthalocyanine, aluminum chlorophthalocyanine, indium chlorophthalocyanine gallium chlorophthalocyanine, and the phthalocyanine with oxygen coordination such as vanadyl phthalocyanine and titanyl phthalocyanine. However, the phthalocyanine series pigment is not limited thereto.

In addition, the polyaromatic compound is exemplified by anthracene, tetracene, pentacene, and their derivatives. However, the polyaromatic compound is not limited thereto.

In addition, the charge transfer complex is exemplified by hydrazone compound, pyrazoline compound, triphenylmethane compound, and triphenylamine compound. However, the charge transfer complex is not limited thereto.

In addition, the electrical conductive organic charge transfer complex is exemplified by tetrathiofulvalene and tetraphenyltetrathiofulvalene. However, the electrical conductive organic charge transfer complex is not limited its material thereto.

In addition, the electrical conductive high polymer material for donating the electron is exemplified by the above mentioned P3HT, poly(3-alkylthiophene), poly-paraphenylenevinylene derivatives, polyfluorene derivatives, thiophene series polymer, oligomer of the electrical conductive high polymer which are soluble to the organic solvent. However, the electrical conductive high polymer material is not limited thereto.

In addition, the electron accepting semiconductor used in the mixing layer 23 is realized by the [6 , 6]-phenyl C61 - butyric acid methyl ester (Hereinafter referred to as PCBM). However, the electron accepting semiconductor is not limited thereto and may employ its material such as compound semiconductor nanocrystal having the grain diameter from 1 nanometer to about 100 nanometers, the low molecular material and the electrical conductive high polymer material such as the fullerene including C₆₀, C₇₀, and _{C84}, and carbon nanotube. In addition, the compound semiconductor nanocrystal is not limited its shape, in particular, and may have the rod-shape, spherical shape, and the tetrapod shape. The specific material of the compound semiconductor nanocrystal is exemplified by III-V compound semiconductor of InP, InAs, GaP, GaAs, III-VI compound semiconductor material of CdSe, CdS, CdTe, and ZnS, and oxide semiconductor of ZnO, SiO₂ TiO₂ Al₂O₃, and CuInSe₂, CuInS. However, the material of the compound semiconductor nano crystal is not limited thereto. In addition, the mixing layer 23 is preferably formed to have a plurality of compound semiconductor nanocrystals having the rod shapes which are arranged at 200 nanometers or less intervals while contacting the first electron transport layer 24. However, the intervals of them are not limited.

In addition, the electron donating semiconductor and the electron accepting semiconductor of the mixing layer 23 is not limited to the high polymer material and also to the low molecule material, and may employ both the high polymer material and the low molecule material.

In addition, the material of the hole transport layer 22 interposed between the positive electrode 21 and the mixing layer 23 is polyethylenedioxythiophene : poly(styrenesulfonate). (PEDOT : PSS) However, the material is not limited thereto. In addition, the hole transport layer 22 may be made of compound having the hole transportability, hole transport effect from the mixing layer 23, good hole transport effect with respect to the positive electrode 21, the electron blocking property, and the thin film formability. Specifically, the material is exemplified by the high polymer material such as the electrical conductive high polymer such as phthalocyanine derivatives, naphthalocyanine derivatives, porphyrin derivatives, aromatic diamine such as N,N'-bis(3-methlphenyl)-(1,1'-biphenyl)-4,4'-diamine (TPD), 4,4'-bis [N- (naphthyl)-N-phenyl-amino] biphenyl (α-NPD: alpha-NPD), oxazole, oxadiazole, triazole, imidazole, imidazolone, stilbene derivatives, pyrazoline derivatives, tetrahydroimidazole, butadiene, 4,4',4" - tris [(3-methylphenyl) phenylamino] triphenylamine (m-MTDATA), and polyvinyl carbazole, polysilane, aminopyridine derivatives, polyethylenedioxidethiophene (PEDOT). However, the material is not limited thereto. In addition, the inorganic oxide composition having the hole transport property such as molybdic anhydride, vanadium pentoxide, tungsten trioxide, and rhenium oxide, and the p-type semiconductor such as nickel oxide, and the inorganic oxide compound such as oxidized copper may be used. In addition, as long as the inorganic compound has the hole transport property, the inorganic material is not limited thereto.

In addition, the first electron transport layer 24 and the second electron transport layer 25 may be made of material such as bathocuproin, bathophenanthroline, the derivatives of them, TPBi, silole compound, triazole compound, tris(8-hydroxyquinato) aluminum complex, bis (2-methyl-8- quinolinato) aluminum complex, oxadiazole compound, distyrylarylene derivatives, silole compound, TPBI (2,2',2"-(1,3,5-benzenetriyl)tris[1-phenyl-1H-benzimidazole]. However, any material will do as long as the material has the electron transport property. Therefore, the material is not limited thereto. The first electron transport layer 24 and the second electron transport layer 25 are made of material as follows. "Compound semiconductor nanocrystal explained above as the material of the mixing layer 23" "low molecular material comprising fullerene derivatives having high order fullerene such as C₆₀, C₇₀, C₈₄" "electrical conductive high polymer" "carbon nanotube" That is, any material will do as long as the material has the electron transport property. Therefore, the material is not limited thereto. In addition, the first electron transport layer 24 and the second electron transport layer 25 are preferably made of material having the electron mobility of 10⁻⁶ cm²/Vs or more, and are more preferably made of material having the electron mobility of 10⁻⁵ cm²/Vs.

In addition, the above mentioned surface protection layer 3 is selected its material having the gas barrier property such as fluorine series compound, fluorine series high molecular, other organic molecule, and the high polymer material. In addition, the surface protection layer 3 may be formed on one surface side of the substrate 1 by means of the deposition method, the sputtering method, the CVD method, and the plasma polymerization method. In addition, a method of coating the solution of high polymer material by the method of such as spin coating and curing it by the ultraviolet or heat may be employed. In addition, other method may be employed in the forming. In addition, the surface protection layer 3 may comprise a multilayer film comprising an electrical insulation film made of commodity polymer, Al film having the gas barrier property, and an electrical insulation film made of commodity polymer. In this case, each the electrical insulation film is formed by means of the coating method and the metal film is made by a method of being capable of forming the high dense metal film such as sputtering method. In addition, the surface protection layer 3 may be formed by a film like structural body or plate like structural body having the light transmissive property and the gas barrier property. In the former case, the film like structural body may be adhered to the peripheral portion of one surface of the substrate 1 by means of the vacuum lamination method. In the later case, the plate like structural body may be adhered to the peripheral portion of one surface of the substrate by means of the sealing agent (glue) such as the ultraviolet curing resin. When employing the surface protection layer 3 having the light transmissive property, it is possible to form the negative electrode 26 by the transparent electrode. Consequently, the negative electrode 26 allows the solar light to arrive at the mixing layer 23 through the surface protection layer 3 and the negative electrode 26. Consequently, it is possible to eliminate the necessary of forming the substrate 1 by the transparent substrate. In addition, it is possible to eliminate the necessary of forming the positive electrode by the transparent electrode. In addition, if the solar light is provided to the mixing layer 23 from a side of the surface protection layer 3, it is preferred to prepare the surface protection layer 3 with its light transmissibility of 70 percents or more.

In addition, in the organic solar cell of this embodiment, one surface of the substrate 1 is provided with an external connection electrode (not shown) which is electrically connected to the positive electrode 21 and is provided with an external connection electrode 26a which is electrically connected to the negative electrode 26. In one surface side of the substrate 1, a side surface of the organic solar cell element 2 is provided with the electrical insulation film 4 for electrically insulate the positive electrode 21 from the connection portion between the negative electrode 26 and the external connection electrode 26a.

In addition, in the components shown in Fig. 1, the organic solar cell element 2 comprises the hole transport layer 22 and the first electron transport layer 24. Consequently, the organic solar cell element 2 has the multilayer structure of the positive electrode 21 / the hole transport layer 22 / the mixing layer 23 / the first electron transport layer 24 / the second electron transport layer 25 / the negative electrode 26. However, the multilayer structure of the organic solar cell element 2 is not limited thereto. That is, the organic solar cell element 2 is only required to have the positive electrode layer 21, the negative electrode 26, the mixing layer 23 between the positive electrode layer 21 and the negative electrode 26, and the second electron transport layer 25 which is in contact with the negative electrode 26. Therefore, for example, the organic solar cell element 2 may have the multilayer structure of the positive electrode 21 / the mixing layer 23 / the second electron transport layer 25 / the negative electrode 26. In addition, the organic solar cell element 2 may have the multilayer structure of the positive electrode 21 / the hole transport layer 22 / the mixing layer / the second electron transport layer 25 / the negative electrode 26. In addition, the organic solar cell element 2 may have the multilayer structure of the positive electrode 21 / the mixing layer 23 / the first electron transport layer 24 / the second electron transport layer 25 / the negative electrode 26.

However, as a result of the research, the inventor of this application learned the fact of improving the durability of the organic solar cell by employing the second electron transport layer 25 with the projections between the mixing layer 23 and the negative electrode 26 such that the projections are in contact with the negative electrode 26.

Therefore, in order to improve the adhesiveness of the negative electrode 26 with respect to the foundation of the negative electrode 26 and the prevention of accumulating the electrical charge generated in the mixing layer 23 when generating the electrical power, the organic solar cell of this embodiment employs the second electron transport layer 25 having the projections which are in contact with the boundary of a contact portion with respect to the negative electrode 26.

The above knowledge is explained with Fig. 2 to Fig. 4. Fig. 2, Fig. 3, and Fig. 4 show the properties of the example 1, the example 2, and the comparative example of the organic solar cells, respectively. In addition, the example 1, the example 2, and the comparative example have no first electron transport layers, respectively. In addition, instead of the second electron transport layer 25, the comparative example has an electron transport layer having no projections.

The organic solar cell of example 1 and example 2 has a substrate 1 made of glass substrate, a positive electrode 21 made of ITO film, and the hole transport layer 22 on one surface side of the substrate 1 formed with the positive electrode 1. When forming the hole transport layer 22, the hole transport layer 22 is made of material of PEDOT : PSS (manufactured by STARCK inc) to have a thickness of 40 nanometers. In addition, as to the pretreatment of forming the hole transport layer 22, performing the ultrasonic cleaning by acetone for 10 minutes, isopropyl alcohol for 10 minutes, Semicoclean (trade name) for 10 minutes, and ultrapure water for 10 minutes are made in order, and then performing the surface cleaning process by UV ozone cleaning apparatus for 10 minutes is made.

In addition, when forming the mixing layer 23, prepareing a mixture of "P3HT (Regioregular type manufactured by Merck Co., Ltd.) as the electron donating semiconductor" and "PCBM (manufactured by Solenne Co., Ltd) which is the fullerene derivatives as the electron accepting semiconductor (hole donating semiconductor)" to have a ratio of P3HT to PCBM of 1 : 0.7 is performed. Then, dissolving the mixture to the mixed solvent of 1,2-dichlorobenzene and chloroform having a ratio of 1,2-dichlorobenzene to chloroform of 6 : 4 is made. Then, transporting the substrate 1 formed with the positive electrode 21 and the hole transport layer 22 to the glove box having the dry nitrogen atmosphere at dew point of 76 degrees C before zero degree Celsius at 1 parts per million or less is made. Then, forming the mixing layer 23 having the thickness of 200 nanometers on the hole transport layer 22 by means of the spin coat with the solution having the mixed solvent with P3HT and PCBM.

Then, transporting the substrate 1 formed with the positive electrode 21, the hole transport layer 22, and the mixing layer 23 to the vacuum deposition equipment and then forming the second electron transport layer 25 and the negative electrode 26 in order are performed. When forming the second electron transport layer 25, the second electron transport layer 25 in the example 1 is made of material of C₆₀ which is a type of the fullerene to have a deposition average thickness of 3 nanometers. The second electron transport layer 25 in the example 2 is made of material of C₇₀ which is a type of the fullerene to have the deposition average thickness of 3 nanometers. In addition, the electron transport layer in the comparative example is made of material of C₆₀ which is a type of fullerene to have the deposition average thickness of 1 nanometer. In addition, the deposition average thicknesses of them are values measured by the crystal oscillator in the vacuum deposition equipment. Therefore, in a case of having the projections like the second electron transport layer 25, the deposition average thickness is defined by the value of averaging the height. In addition, as mentioned below, the second electron transport layers 25 of the example 1 and the example 2 have projections having dome shapes to have an average height of 5 nanometers and average diameter of 100 nanometers. The electron transport layer in the comparative example has no dome shaped projections 25a, thereby having a comparative flat surface.

In addition, when forming the negative electrode 26, forming the negative electrode 25 having the lithium fluoride film having the thickness of 0.5 nanometers and Al film having the thickness of 80 nanometers by means of the vacuum deposition method is preformed.

Then, transporting the substrate 1 formed with the positive electrode 21, the hole transport layer 22, the mixing layer 23, the second electron transport layer 25, and the negative electrode 26 to the glove box having the dry nitride atmosphere at 76 degrees C below zero degree Celsius without exposing to the air. In contrast, a getter kneading the calcium oxide as the water absorption agent is adhered to the sealing plate made of glass. In addition, the peripheral portion of the sealing plate is provided with the sealing agent of the ultraviolet curing agent, in advance. Then, in the glove box, the substrate 1 is pasted into the sealing plate made of the glass with the sealing agent. Then, the sealing agent is cured by the ultraviolet rays. Consequently, the surface protection layer 3 having the sealing plate having the plate like structure is formed.

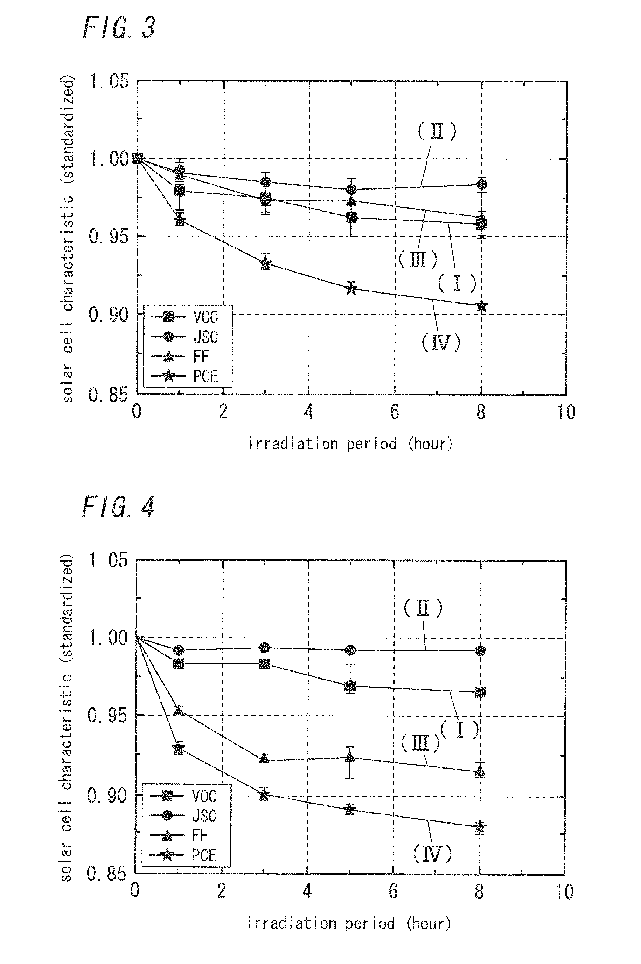

The above mentioned I to IV of Fig. 2 to Fig. 4 show measurement results of the solar cell characteristics (I : open voltage (VOC), II : short circuit current density (JSC), III : form factor (FF) IV : conversion efficiency (PCE)) which are measured under a condition where the pseudo solar light of 1.5 G of air mass sensor and 100 milliwatt per square centimeter is applied to the solar cells of the example 1, the example 2, and the comparative example. As will be understood from Fig. 2 and Fig. 3, the organic solar cells in Fig. 2, Fig. 3 have 90 to 95 percents of the maintenance ratio of the efficiency after 8 hours from the start of the irradiation. In contrast, as will be understood from Fig. 4, the organic solar cell of the comparative example decreases its conversion efficiency (PCE) to 88 percents after 8 hours from the start of the irradiation. That is, the example 1 and example 2 achieve the long life, compared with the comparative example. In addition, the solar cell characteristics in Fig. 2 to Fig. 4 are values normalized in the example 1, the example 2, and the comparative example under a condition where the value at the start of the irradiation is defined as "1".

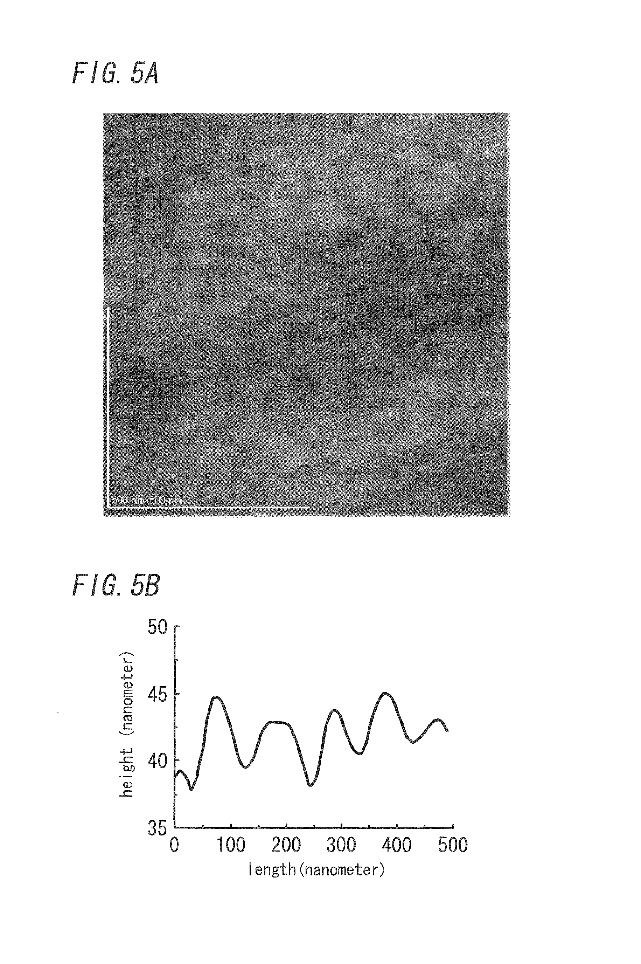

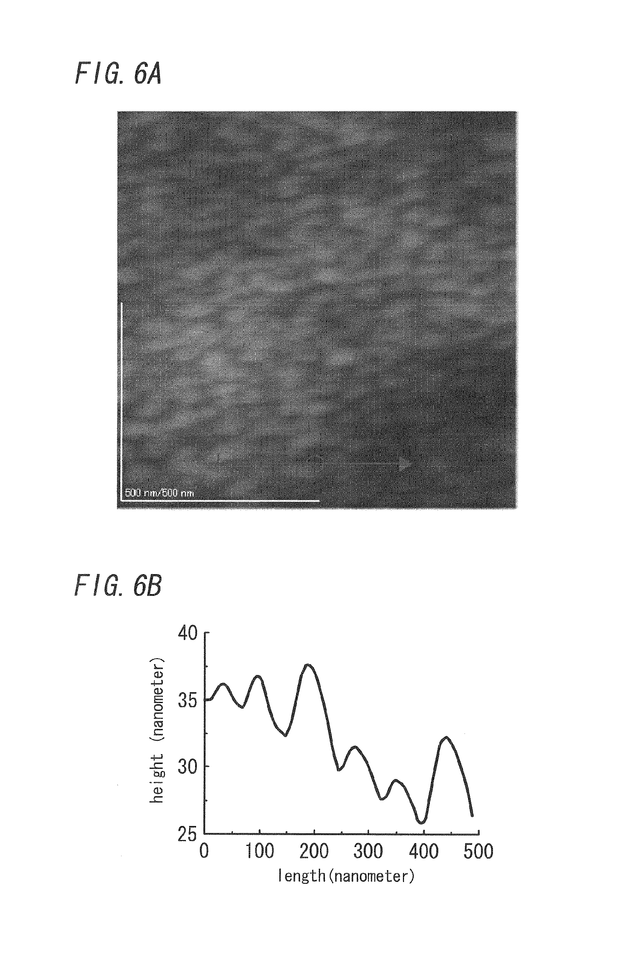

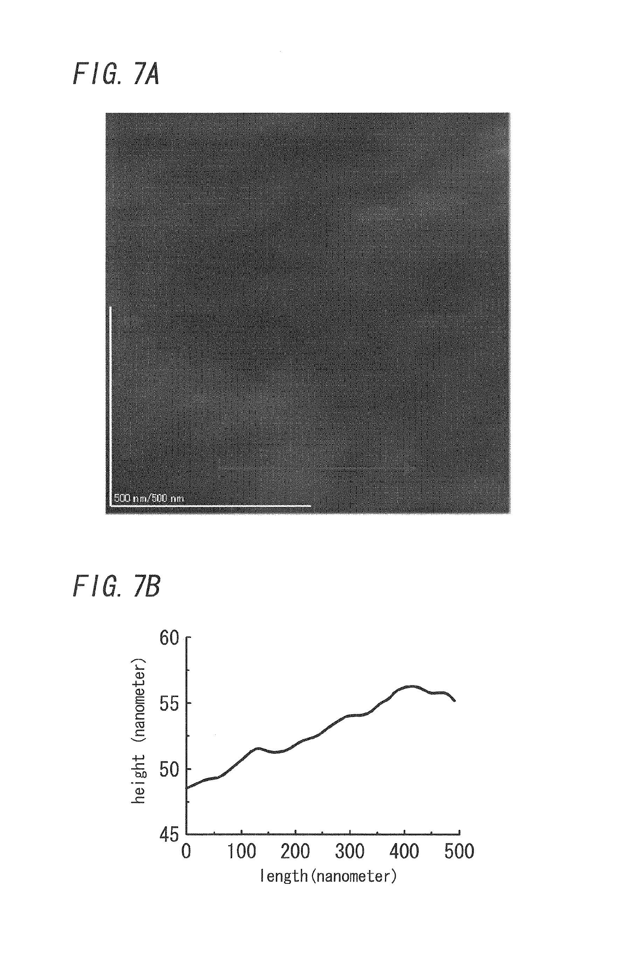

In addition, "the surface shapes of the second electron transport layers 25 of the example 1 and the example 2 and the surface shape of the electron transport layer of the comparative example" observed by the AFM (which stands for Atomic Force Microscope) are shown in Fig. 5, Fig. 6, and Fig. 7. In Fig. 5A, Fig. 6A, and Fig. 7A show AFM pictures, and Fig. 5B, Fig. 6B, and Fig. 7B show cross sections of the AFM pictures. According to Fig. 5 and Fig. 6, the second electron transport layers 25 of the example 1 and the example 2 are confirmed to have the surface shapes having dome shapes with the average height of 5 nanometers and the average diameter of 100 nanometers. According to Fig. 7, the electron transport layer of the comparative example is confirmed to have the surface shape which is comparatively flat shape.

The organic solar cell of this embodiment explained above comprises a mixing layer 23, the negative electrode 26, and the second electron transport layer 25 which is disposed between the mixing layer 23 and the negative electrode 26 and which is provided with projections in contact with the negative electrode 26. With this configuration, the adhesiveness in the boundary surface existing between the mixing layer 23 and the negative electrode 26 is improved. In addition, when generating the electrical charge in the mixing layer generated by the light absorption of the operation of the power generation, the configuration prevents the accumulation of the electrical charge and allows the electrical charge to the move into the negative electrode. Consequently, the long life is achieved.

In addition, the organic solar cell of this embodiment comprises the second electron transport layer 25 formed with the dome-shaped projections 25a located in the negative electrode side 26 in the mixing layer 23. Consequently, compared with a case where the projection in the contact boundary formed by contacting the second electron transport layer 25 with the negative electrode is formed to have a stripe arrangement, it is possible to increase the contact boundary between the second electron transport layer 25 and the negative electrode 26 to pass the electrical charge. Therefore, this configuration increases the effect of prevention of the accumulation of the electrical charge, whereby long life is achieved. In addition, the projections 25a are not limited dome shapes, and may have dot shape. Employing the dot-shaped projections 25a achieves the effect, similar to employing the dome-shaped projections 25a.

By the way, the material of the second electron transport layer 25 is exemplified by the organic semiconductor material having the electron transport property such as the fullerene C₆₀ and the fullerene C₇₀ which have the chemical structural stability. In addition, the deposition average thickness of the second electron transport layer 25 formed by the vacuum deposition method is required "to have a thickness to a certain extent of not increasing the accumulation of the electrical charge of the solar cell" and "to have the surface with the projections". Therefore, the second electron transport layer 25 preferably has a thickness of 2 nanometers to 5 nanometers, and more preferably has a thickness of 2.5 nanometers to 4 nanometers. In addition, if the deposition average thickness is too thin, it is impossible to form the projections, like the comparative example. In contrast, if the deposition average thickness is too thick, the gaps between the projections next to each other are filled, whereby the continuous film having the flat surface is formed. Therefore, the adhesiveness with respect to the negative electrode is decreased, whereby holding the electrical charge in the boundary causes the decrease of the life time of the solar cell.

In addition, when forming the second electron transport layer 25 by the vacuum deposition method, the second electron transport layer 25 is required to have a surface shape which is capable of being easily covered by the negative electrode without any space. ("Covered by the negative electrode without any space" means "covered without forming the fine voids") In addition, the projections 25a preferably have tapers such as trapezoidal shapes, compared with the cross sectional rectangular shape. In addition, the projections more preferably have a dome shapes.

In addition, the sizes of the projections 25a are determined to strongly attach the second electron transport layer 25 with the negative electrode 26 by covering, without space, the surface with the projection of the second electron transport layer by the negative electrode 26. The projections 25a preferably has sizes which has a ratio of the average height to the average diameter as of 1 / 20 and which has the average height of 3 nanometers to 8 nanometers. In addition, in view of the diffusion property of the electrical charge in the power generation of the organic solar cell, the average height of the projections 25a preferably has 4 nanometers to 6 nanometers. In addition, if the value of average height / average diameter is too small, the surface of the second electron transport layer 25 becomes flat, whereby adhesiveness is decreased and the life time characteristic is decreased. In contrast, if the value of average height / average diameter is too large, it is hard to enter the deposition material into the recess when forming the negative electrode 26 by the vacuum deposition method. (The deposition material is the material of the negative electrode 26.) So, this causes the voids. When the organic solar cell generates the power, the electrical charge is stored around the voids. So, the life time characteristic is decreased.

That is, in the organic solar cell of this embodiment, forming the projection to have the height of 4 nanometers to 6 nanometers and to have a dome shape to have the average diameter of 80 nanometers to 120 nanometers. Consequently, the negative electrode 26 is adhered to the second electron transport layer 25 without voids. So, it is possible to improve the prevention of accmulating the electrical charge, whereby the long life is achieved.

## Claims

1. An organic solar cell comprising:
a first electrode configured to collect holes;
a second electrode configured to collect electrons;
a mixing layer interposed between said first electrode and said second electrode, said mixing layer comprising an electron donating semiconductor and an electron accepting semiconductor;
a first electron transport layer and a second electron transport layer which are interposed between said mixing layer and said second electrode,
wherein
said second electron transport layer has a plurality of projections which are in contact with said second electrode.

2. The organic solar cell as set forth in claim 1, wherein
each said projections is formed to have a dome shape or a dot shape.

3. The organic solar cell as set forth in claim 2, wherein
each said projections is formed to have the dome shape to have a height from 4 nanometers or more to 6 nanometers or less and an average diameter from 80 nanometers or more to 120 nanometers or less.
